# EUROPEAN PATENT SPECIFICATION

(11) **EP 2 371 475 B1**
(45) Date of publication and mention of the grant of the patent: **15.10.2014**
(21) Application number: 11159396.8
(22) Date of filing: 23.03.2011
(51) Int. Cl.: B23K 26/08, B23K 26/36, B23K 37/02, B23K 26/40

(54) **Device for patterning laminated substrate with guiding bar and roller stage**
Vorrichtung zur Musterung laminierter Substrate mit Führung und Rolle
Dispositif de formation de motifs de substrat stratifié avec une barre de guidage et un banc de rouleaux

(30) Priority: 29.03.2010 JP 2010074090
(43) Date of publication of application: 05.10.2011
(73) Proprietor: Mitsuboshi Diamond Industrial Co., Ltd., Suita-city, Osaka 564-0044 (JP)
(72) Inventor: Akai, Toshio, Suita City, Osaka 564-0044 (JP); Hirono, Yoshifumi, Suita City, Osaka 564-0044 (JP)
(74) Representative: TBK

(56) References cited:
- JP-A- 8 118 045
- JP-A- 8 332 583
- JP-A- 10 027 918
- JP-A- 62 021 491
- JP-A- 2004 351 447
- JP-A- 2007 048 835

## Description

The present invention relates to a patterning device according to the preamble of claim 1 (see, for example JP 62-21491 A), and particularly relates to a device for patterning a laminated substrate for forming grooves in a thin film layer of the laminated substrate.

### 2. Description of the Related Art

In a laminated substrate of a solar battery or the like, a metal film, a semiconductor film, and other thin films are laminated on a glass substrate. A plurality of separating grooves are formed in these thin films as an insulating treatment. These separating grooves are formed by a laser head which uses laser light, or by a mechanical tool which uses a blade edge made of diamond or the like.

Devices such as the one disclosed in JP 2007-48835 A are known in conventional practice as the devices for "patterning," as described above, whereby grooves are formed in thin films. The patterning device disclosed in JP 2007-48835 A has a placement table on which a solar battery substrate is placed, and a optical machining system for guiding laser light emitted from a laser oscillator onto the solar battery substrate. The placement table has an X stage and a Y stage as movement mechanisms which can move respectively in an X-axis direction and a Y-axis direction, and the placement table is designed so as to be capable of moving the solar battery substrate on the placement table relative to the optical machining system.

The devices disclosed in JP 10-027918 A and JP 08-118045 A are provided as other patterning devices. These patterning devices comprise a supply roller for supplying a continuous substrate, a winding roller for winding the substrate, a roller-shaped stage disposed between the supply roller and the winding roller for supporting the rear surface of the substrate, and an optical system for guiding laser light onto the substrate. The substrate here is irradiated with laser light while the substrate is being supplied from the supply roller, and a groove is formed along the direction in which the substrate moves.

In a patterning process such as the optical machining system previously described, the table is preferably moved at a high speed in order to reduce takt time. To form the groove with precision, the gap between the processing head and the substrate must be managed with high precision, and the table placement surface on which the solar battery substrate or other workpiece is placed must be finished with high surface precision.

In recent years, solar battery substrates have become larger, and the tables upon which the substrates are to be placed have therefore also increased in size. Generally, the tables are often made of stone, and when the size of a table increases, its weight increases as well. It is therefore difficult to move such a heavy table at a high speed, and high surface precision across a wider placement surface leads to cost increase.

With a device such as the one disclosed in JP 10-027918 A or JP 08-118045 A, there is no need to move a heavy table in order to support the rear surface of the substrate on a roller-shaped stage. However, with the devices of the configuration disclosed in JP 10-027918 A and JP 08-118045 A, there is no disclosure of how the laser head and the roller-shaped stage are positioned with precision. Specifically, there is no disclosure of the configuration for precisely managing the gap between these two components, and a groove cannot be formed with precision with such a device.

### SUMMARY OF THE INVENTION

An object of the present invention is to make it possible to perform patterning process on a solar battery substrate or another workpiece of a non-continuous type at a high speed and with high precision without resulting in a cost increase.

A device for patterning a laminated substrate according to a first aspect of the present invention is a device as defined in claim 1.

With this device, the laminated substrate is placed on the external peripheral surface of the roller stage and conveyed underneath the guide bar. At this time, the processing head is mounted on the guide bar, and a groove is formed by the processing head in the laminated substrate conveyed on the roller stage.

Since the laminated substrate is supported while in linear contact with the external peripheral surface of the roller stage, the surface area of the part in contact is small. Therefore, high surface precision can readily be achieved in the contact part. Increasing the surface precision of the contact part also does not lead to cost increase. Furthermore, since both the processing head and the roller stage are supported on the pair of support parts, the space between the two components, and consequently the relative positions of the processing head and the laminated substrate, can readily be set with high precision. The amount of time needed for forming the groove can also be reduced.

In the device for patterning a laminated substrate according to the first aspect of the present invention, the roller stage is supported so as to be capable of being raised and lowered by the pair of support parts.

The roller stage can herein be raised and lowered to create a sufficient gap between the roller stage and the processing head mounted on the guide bar, and the laminated substrate can be smoothly conveyed onto the roller stage.

The device for patterning a laminated substrate according to a second aspect of the present invention is the device according to the first aspect, wherein the guide bar is supported so as to be capable of being raised and lowered by the pair of support parts.

The guide bar herein can be raised and lowered and the relative positions between the substrate and the processing head mounted on the guide bar can readily be adjusted.

The device for patterning a laminated substrate according to a third aspect of the present invention is the device according to the first or second aspect, wherein the roller stage is supported by the voller raising/lowering mechanisms so that two ends thereof can be raised and lowered independently of each other relative to the pair of support parts.

Since the ends of the roller stage can herein be raised and lowered independently, the incline of the laminated substrate placed on the roller stage can be adjusted.

The device for patterning a laminated substrate according to a fourth aspect of the present invention is the device according to any of the first through third aspects, wherein the processing head is movable relative to the guide bar in a direction perpendicular to a direction in which the substrate is conveyed.

Multiple grooves can herein be formed readily by a small number of processing heads.

The device for patterning a laminated substrate according to a fifth aspect of the present invention is the device according to any of the first through fourth aspects, wherein the substrate conveying mechanism has a group of chuck mechanisms for clamping the ends of the laminated substrate in the conveying direction of the laminated substrate, the chuck mechanisms being disposed upstream and downstream in the substrate conveying direction on either side of the roller stage.

The laminated substrate is herein clamped at both ends by the respective chuck mechanisms and is conveyed over the roller stage.

The device for patterning a laminated substrate according to a sixth aspect of the present invention is the device according to the fifth aspect, wherein the group of chuck mechanisms clamps the laminated substrate so that the portion of the laminated substrate placed on the roller stage is higher than the ends of the laminated substrate in the conveying direction.

The laminated substrate is herein clamped at both ends by the chuck mechanisms and is flexed so that the portion placed on the roller stage is at the highest. The laminated substrate and the roller stage are therefore firmly pressed together, allowing a groove to be formed with precision.

The device for patterning a laminated substrate according to an seventh aspect of the present invention is the device according to any of the first through sixth aspects, further comprising a sensor which is provided at the guide bar and which measures the distance from the sensor to the laminated substrate placed on the roller stage.

The distance between the sensor and the laminated substrate on the roller stage can herein be measured by the sensor, and the relative positions including the gap between the laminated substrate and the processing head can readily be adjusted based on the measurement results.

In the present invention described above, since the laminated substrate is supported by the roller stage and the roller stage and the processing head are supported by the pair of support parts, groove formation at a high speed is possible and a groove can be formed in the laminated substrate with high precision without resulting in a cost increase.

### BRIEF DESCRIPTION OF THE DRAWINGS

FIG. 1 is a schematic view of a patterning device according to an embodiment of the present invention;
FIG. 2 is a front view of the patterning device;
FIG. 3 is a schematic side view of the device;
FIG. 4 is an external view showing part of the substrate conveying mechanism; and
FIG. 5 is an external view showing the configuration for clamping the substrate in the substrate conveying mechanism.

### DESCRIPTION OF THE PREFERRED EMBODIMENTS

### [Overall Configuration]

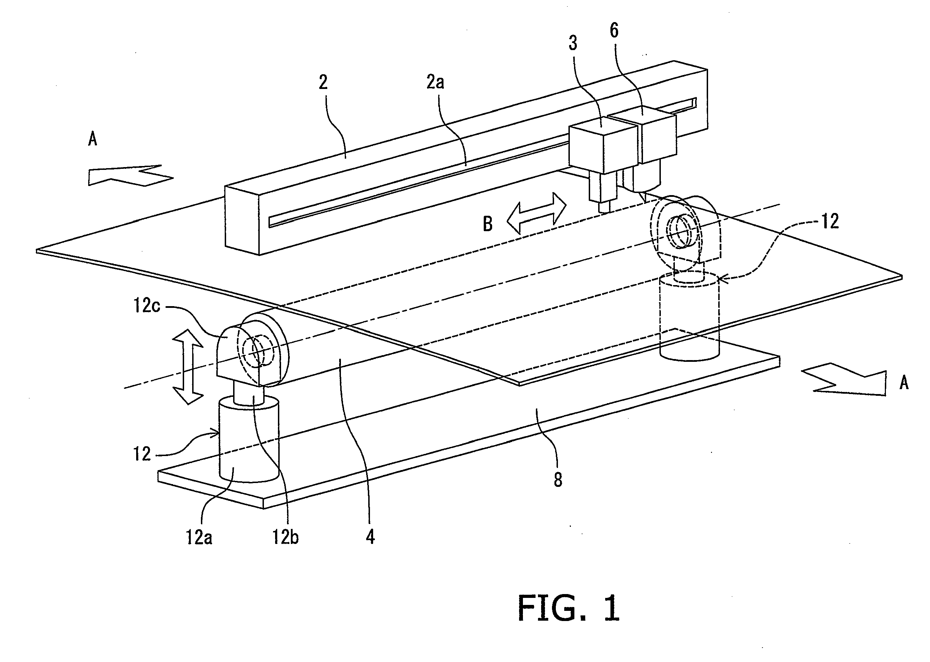

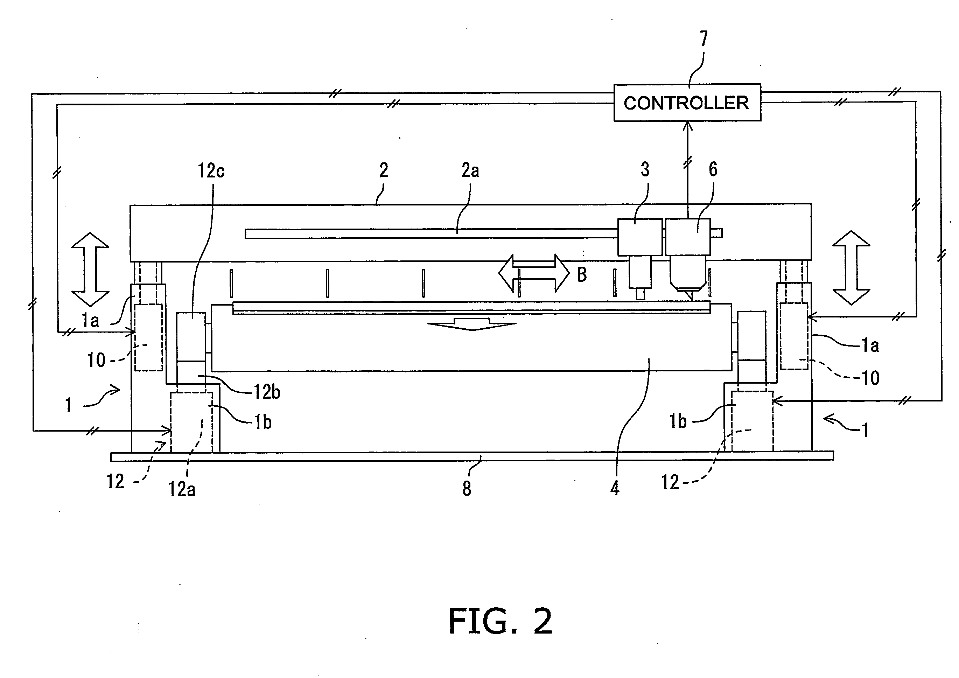

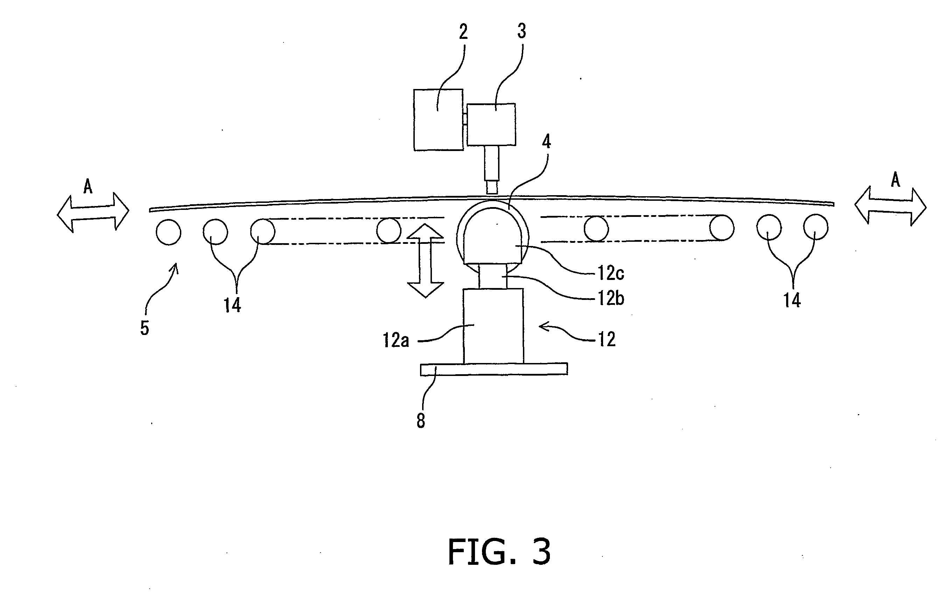

A patterning device according to an embodiment of the present invention is shown in FIGS. 1 through 3. FIG. 1 is a schematic view of the patterning device, FIG. 2 is a front view of the same, and FIG. 3 is a schematic side view of the same.

This patterning device is a device for forming a groove for an insulation treatment in a thin film layer of a solar battery substrate as a laminated substrate. The solar battery substrate (hereinbelow referred to simply as the substrate) is conveyed in the direction of arrow A in FIG. 1. The conveying mechanism is omitted from FIGS. 1 and 2 (a part of which is shown in FIG. 3). The patterning device comprises primarily a pair of left and right support parts 1, a guide bar 2, a processing head 3 for forming a groove, a roller stage 4, a conveying mechanism 5 (see FIGS. 3 through 5), and a non-contact displacement sensor 6. The patterning device also has a controller 7 composed of a microcomputer or the like.

### [Support Parts]

The pair of support parts 1 are disposed at a predetermined interval from each other, and are both fixed on a base frame 8. Each support part 1 has a guide bar support part 1a on its external side, and a roller stage support part 1b on its internal side.

### [Guide Bar]

The guide bar 2 is disposed to extend between the pair of support parts 1, and the ends of the guide bar 2 are positioned above the guide bar support parts 1a of the support parts 1. The guide bar 2 can be raised and lowered by guide bar raising/lowering mechanisms 10 provided inside the guide bar support parts 1a of the support parts 1. The guide bar raising/lowering mechanisms 10 each have a respective servomotor and mechanism for raising and lowering the guide bar 2 through the rotation of the servomotor. In the guide bar 2, a guide groove 2a is formed along the longitudinal direction, i.e. a direction B perpendicular to the conveying direction A of the substrate. The guide groove 2a is provided across nearly the same length as the roller stage 4.

### [Processing head]

The processing head 3 for forming a groove is movable along the guide groove 2a of the guide bar 2, in the direction B perpendicular to the substrate conveying direction A. The processing head 3 can be a laser head which radiates laser light onto the substrate, or a processing head having a blade edge made of diamond or the like.

### [Roller Stage]

The roller stage 4 has a rotating shaft parallel to the direction in which the guide bar 2 extends (the B direction). The roller stage 4 is disposed underneath the guide bar 2 so as to face the processing head 3. The ends of the roller stage 4 are rotatably supported according to the present invention, in roller raising/lowering mechanisms 12 provided in the roller stage support parts 1b of the support parts 1. The substrate is pressed onto the roller stage 4 and conveyed in the A direction. During this conveyance, a groove is formed by the processing head 3. The roller stage 4 is not subjected to any rotational drive force, and the roller stage 4 rotates in response to the conveyance of the substrate.

The roller raising/lowering mechanisms 12 provided in the support parts 1 both have the same configuration. The roller raising/lowering mechanisms 12 have drive parts 12a including servomotors and mechanisms for converting the rotation of the servomotors into a raising and lowering movement, drive rods 12b raised and lowered by the drive parts 12a, and support parts 12c fixed to the distal ends of the drive rods 12b. The ends of the rotating shaft of the roller stage 4 are rotatably supported in the support parts 12c.

The two roller raising/lowering mechanisms 12 are capable of being operated independently, and the incline of the roller stage 4 can be adjusted by controlling the raised or lowered amount of the roller raising/lowering mechanisms 12.

### [Conveying Mechanism]

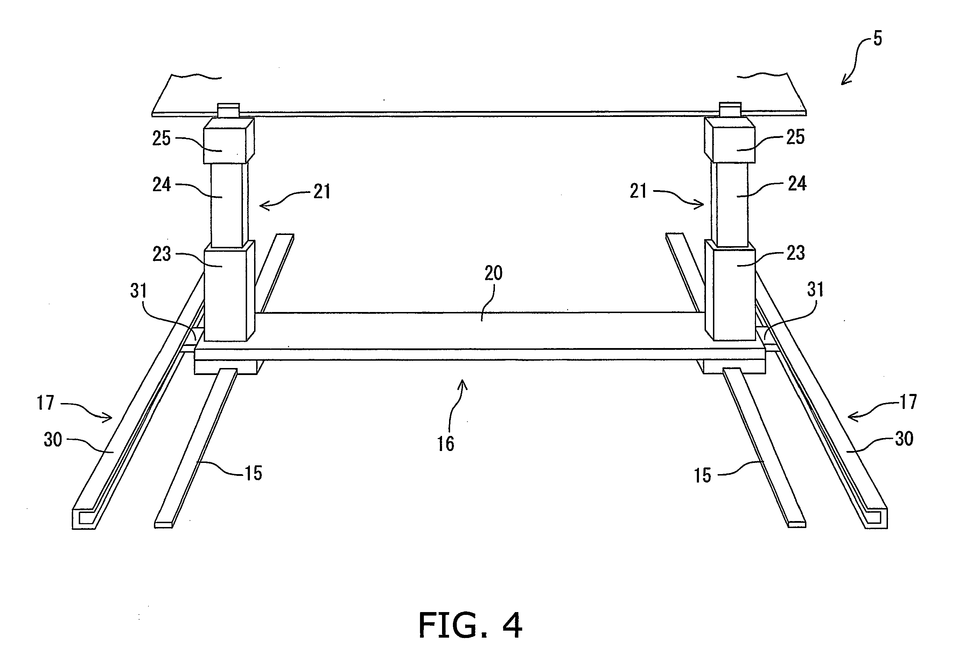

The conveying mechanism 5 is a mechanism for conveying the substrate along the direction A in FIG. 1. The conveying mechanism 5 has a plurality of conveying rollers 14, a pair of guide rails 15, first and second chuck mechanisms 16 (only one chuck mechanism is shown in FIG. 4) which move along the pair of guide rails 15, and linear motor mechanisms 17 for driving the first and second chuck mechanisms 16, as shown in FIGS. 3 and 4.

The conveying rollers 14 are disposed upstream and downstream of the roller stage 4 in the substrate conveying direction. The conveying rollers 14 have rotating shafts parallel to the rotating shaft of the roller stage 4, and the conveying rollers 14 are rotatably supported on a frame (not shown).

The pair of guide rails 15 extends along the substrate conveying direction. Both of the guide rails 15 are formed to curve with an upward curvature as seen from the side (in the direction of the rotating shaft of the roller stage 4) in order to keep the flexion of the substrate constant. More specifically, the guide rails are disposed so that the portions nearest the roller stage 4 are at the highest, and the height positions become progressively lower away from the roller stage 4, both upstream and downstream in the substrate conveying direction.

The first and second chuck mechanisms 16 are disposed downstream and upstream in the substrate conveying direction on either side of the roller stage 4. FIG. 4 is a drawing of the second chuck mechanism 16 disposed downstream in the substrate conveying direction, as seen from the upstream side in the substrate conveying direction. Since the two chuck mechanisms 16 have entirely identical configurations, only the second chuck mechanism 16 is described herein.

The second chuck mechanism 16 has a moving base 20 and a pair of clamp devices 21.

The moving base 20 is a plate-shaped member extending parallel to the rotating shaft of the roller stage 4. The ends of the moving base 20 are slidably engaged with the respective guide rails 15 and are movable in the substrate conveying direction.

The pair of clamp devices 21 are disposed respectively at the ends of the moving base 20. The clamp devices 21 have hydraulic cylinders 23 fixed to the top surface of the moving base 20, and clamp pawls 25 fixed to rods 24 of the hydraulic cylinders 23.

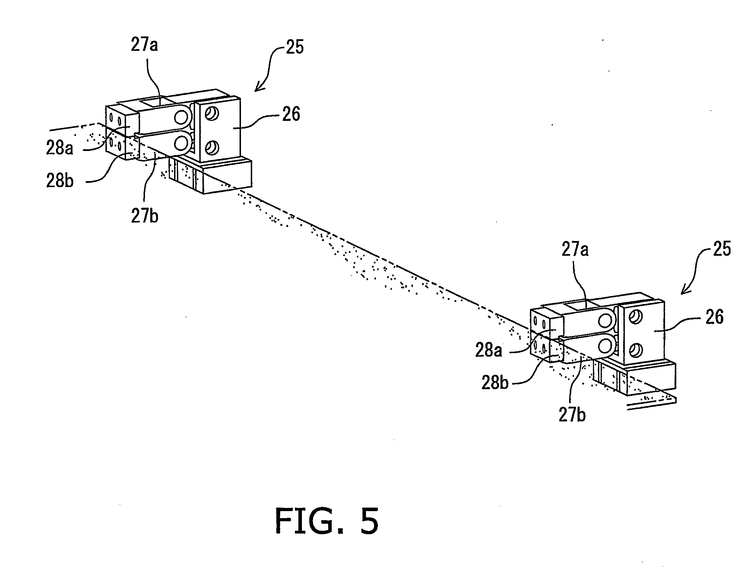

The clamp pawls 25 can be raised and lowered through the driving of the hydraulic cylinders 23. The clamp pawls 25 have casings 26 and pairs of top and bottom turning arms 27a, 27b, as shown in FIG. 5. The casings 26 are fixed to the distal ends of the rods 24. The turning arms 27a, 27b are turnably supported at the proximal ends on the casings 26, and are capable of turning from a vertical state to a horizontal state shown in FIG. 5. Clamping parts 28a, 28b are provided at the distal ends of the turning arms 27a, 27b. Through turning the both pairs of top and bottom turning arms 27a, 27b from the vertical state to the horizontal state and having the substrate held between the top and bottom clamping parts 28a, 28b, the substrate can be clamped.

With a configuration such as the one described above, the upstream end and the downstream end of the substrate in the conveying direction can be clamped by the pair of clamp devices 21.

The linear motor mechanisms 17 are configured with a pair of stationary elements 30 and a pair of mobile elements 31. The stationary elements 30 are disposed on the external sides of the respective guide rails 15, parallel to the guide rails 15. The stationary elements 30 are each formed into a U shape in cross section which opens inward. The mobile elements 31 are provided to protrude outward from the ends of the moving base 20. The mobile elements 31 are each inserted into a corresponding stationary element 30.

With the conveying mechanism 5 of a configuration such as the one described above, the substrate clamped at both ends by the first and second chuck mechanisms 16 which move along the pair of guide rails 15 is conveyed while being bent so that the portion on the roller stage 4 is the highest. Therefore, the rear surface of the substrate is held firmly against the roller stage 4 during the patterning process of the substrate.

### [Non-contact Sensor]

The non-contact displacement sensor 6 can move in the direction B perpendicular to the substrate conveying direction along the guide groove 2a of the guide bar 2, in the same manner as the processing head 3. The non-contact displacement sensor 6 measures the distance between the processing head 3 and the substrate by measuring the distance from itself to the substrate being conveyed over the roller stage 4.

### [Controller]

The measurement results of the non-contact displacement sensor 6 are inputted to the controller 7. The controller 7 controls the raised and lowered amount of the guide bar raising/lowering mechanisms 10 on the basis of the measurement results of the sensor 6, and controls the gap between the roller stage 4 and the processing head 3 supported on the guide bar 2. The controller 7 is capable of controlling the incline of the roller stage 4 on the basis of the measurement results of the sensor 6.

### [Action]

The following is a description of a case in which patterning process is performed by a laser head using laser light. When patterning process is performed using a laser head, the gap between the processing head 3 and the substrate must always be kept constant. In cases in which the processing head 3 uses a diamond cutter or another mechanical tool, patterning process must always be performed at a fixed distance by the distal end of the tool when cutting into the thin film layer of the substrate surface.

In a preparatory stage preceding the patterning process, the roller stage 4 is retracted beneath the conveying rollers 14 by the roller raising/lowering mechanisms 12. Therefore, a comparatively large gap is formed between the roller stage 4 and the processing head 3. The clamp devices 21 of the conveying mechanism 5 are also retracted so that the clamp pawls 25 are positioned underneath the substrate on the conveying rollers 14.

In the state described above, the substrate is conveyed over the conveying rollers 14 and is conveyed onto the roller stage 4. When the substrate is conveyed onto the roller stage 4, the hydraulic cylinders 23 of the clamp devices 21 operate and the clamp pawls 25 are raised to the height of the substrate. The left and right sides of the ends of the substrate are then clamped by the turning arms 27a, 27b of the clamp pawls 25. The roller stage 4 is then raised to a predetermined height. The substrate is thereby flexed so that the portion in contact with the roller stage 4 is at the highest position, as shown in FIG. 3.

The distance between the substrate on the roller stage 4 and the non-contact displacement sensor 6 is herein measured by the non-contact displacement sensor 6, and accordingly the gap between the processing head 3 and the substrate is measured. At this time, the non-contact displacement sensor 6 scans along the guide groove 2a in the direction B perpendicular to the substrate conveying direction, and the gap is measured in multiple locations. The guide bar raising/lowering mechanisms 10 are driven on the basis of the measurement results, and the gap between the substrate on the roller stage 4 and the processing head 3 is adjusted so as to always be maintained at a predetermined gap along the width direction of the substrate.

When the substrate is inclined, i.e. when the gap differs along the width direction of the substrate (direction B), the incline of the substrate is corrected by controlling both of the roller raising/lowering mechanisms 12.

When the patterning process is performed, the ends of the substrate are moved while being clamped by the clamp pawls 25 to ensure the process precision (several dozen µm) required for the patterning process. With the movement provided by the conveying mechanism through rollers, conveyors, and the like, misalignment between the substrate and the rollers or the like makes it difficult to guarantee a process precision of several dozen µm.

Next, with the configuration of the conveying mechanism 5 as shown in FIG. 3, the substrate is conveyed in the direction A while being flexed so that the portion on the roller stage 4 is at the highest position. The substrate is thereby conveyed while reliably remaining in linear contact with the roller stage 4, i.e. a fixed gap from the processing head 3 is always maintained. A groove is formed by the processing head 3 in the thin film layer of the substrate surface while the substrate is conveyed.

When groove formation in the substrate is finished, the processing head 3 is moved a certain span along the guide groove 2a. The process previously described is then repeated.

Multiple grooves can be formed in the substrate by repeating the action described above.

In the above action description, for the sake of convenience in the description, a case was described in which a groove was formed by a single processing head 3. However, usually the present invention may be configured so that a plurality of processing heads 3 are provided, which are capable of synchronized movement along the guide groove 2a.

### [Characteristics]

(1) Due to the support based on the linear contact with the roller stage 4, the substrate can be maintained with high precision and the cost for constructing the device can be kept low, compared to a conventional device which requires high surface precision in a table of large surface area.
(2) Since the processing head 3 and the roller stage 4 are supported by the same support parts 1, the gap between the two components can be readily adjusted with precision.
(3) Since the roller stage 4 can be raised and lowered relative to the support parts 1, when the substrate is conveyed onto the roller stage 4, the space between the processing head 3 and the substrate can be widened, and conveyance of the substrate is facilitated.
(4) Since the guide bar 2 can be raised and lowered, the gap between the processing head 3 mounted on the guide bar 2 and the substrate on the roller stage 4 can readily be adjusted with precision.
(5) Since the ends of the roller stage 4 can be raised and lowered independently of each other, the incline of the substrate on the roller stage 4 can be corrected.
(6) Since the processing head 3 moves freely along the guide groove 2a of the guide bar 2, multiple grooves can be formed readily by a small number of processing heads.
(7) Since the non-contact displacement sensor 6 is provided parallel to the processing head 3, the gap between the processing head 3 and the substrate can be measured readily.

### [Other Embodiments]

The present invention is not limited to the embodiment described above, and various modifications and revisions can be made without deviating from the scope of the invention.
(a) The configuration of the mechanism for raising and lowering the guide bar 2 and the roller stage 4 is not limited to that of the above embodiment. Actuators other than servomotors may be used.
(b) The configuration of the clamp device for clamping the ends of the substrate is not limited to that of the above embodiment. For example, the clamp device may be configured based on vacuum chucks for holding the surface at both ends of the substrate through suction.
(c) A plurality of conveying rollers were used in part of the conveying mechanism, but a belt conveyor or another conveying member may also be used, for example.
(d) In the above embodiment, a description was given using a solar battery substrate as an example of a laminated substrate, but the present invention can of course be similarly applied to patterning of other laminated substrates as well.

### KEY

- 1: Support parts
- 2: Guide bar
- 2a: Guide groove
- 3: Processing head
- 4: Roller stage
- 5: Conveying mechanism
- 6: Non-contact displacement sensor
- 10: Guide bar raising/lowering mechanisms
- 12: Roller raising/lowering mechanisms
- 16: First and second chuck mechanisms
- 21: Clamp devices

The present invention intends to make it possible to perform patterning on a solar battery substrate or another laminated substrate with high speed and high precision without resulting in a cost increase.

## Claims

1. A patterning device for forming a groove in a thin film layer of a laminated substrate, the patterning device comprising:
a pair of support parts (1) disposed at a predetermined interval;
a guide bar (2) disposed between the pair of support parts (1) and supported at either end by the pair of support parts (1), the guide bar (2) allowing the laminated substrate to pass thereunder;
a processing head (3) mounted on the guide bar (2) for patterning the thin film layer;
a roller stage (4) disposed to face the processing head (3) and is rotatably supported by the pair of support parts (1), the roller stage (4) includes an external peripheral surface on which the laminated substrate is placed; and
a conveying mechanism (5). For conveying, in a preparatory stage preceding the patterning process, the laminated substrate onto the roller stage (4) and conveying, after the patterning process, the laminated substrate placed on the roller stage (4),
**characterized by** the roller stage (4) disposed between the pair of support parts (1),
a roller raising/lowering mechanism (12), wherein the roller stage (4) is capable of being raised and lowered in a retracted position by the pair of support parts (1), by the roller raising/lowering mechanisms (12), and is disposed in the retracted position beneath the conveying mechanism (5).

2. The device for patterning a laminated substrate according to Claim 1, wherein the guide bar (2) is supported so as to be capable of being raised and lowered by the pair of support parts (1).

3. The device for patterning a laminated substrate according to Claim 1 or 2, wherein the roller stage (4) is supported by the roller raising/lowering mechanisms (12) so that two ends thereof can be raised and lowered independently of each other relative to the pair of support parts(1).

4. The device for patterning a laminated substrate according to any of Claims 1 through 3, wherein the processing head (3) is movable relative to the guide bar (2) in a direction (B) perpendicular to a direction (A) in which the laminated substrate is conveyed.

5. The device for patterning a laminated substrate according to any of Claims 1 through 4, wherein the conveying mechanism (5) has a group of chuck mechanisms (16) for clamping the ends of the laminated substrate in a conveying direction (A) in which the laminated substrate is conveyed, the chuck mechanisms (16) being disposed upstream and downstream in the conveying direction (A) on either side of the roller stage (4).

6. The device for patterning a laminated substrate according to Claim 5, wherein the group of chuck mechanisms (16) clamps the laminated substrate so that the portion of the laminated substrate placed on the roller stage (4) is higher than the ends of the laminated substrate in the conveying direction (A).

7. The device for patterning a laminated substrate according to any of Claims 1 through 6, further comprising a sensor (6) for measuring the distance from the sensor (6) to the laminated substrate placed on the roller stage (4), the sensor (6) being provided at the guide bar (2).

## Patentansprüche

1. Musterungsvorrichtung zum Ausbilden einer Nut in einer dünnen Filmschicht eines Schichtsubstrats, wobei die Musterungsvorrichtung Folgendes umfasst:
ein Paar Trageteile (1), die in einem vorbestimmten Intervall angeordnet sind;
eine Führungsstange (2), die zwischen dem Paar Trageteilen (1) angeordnet ist und an jedem Ende durch das Paar Trageteile (1) getragen wird, wobei die Führungsstange (2) dem Schichtsubstrat erlaubt, darunter durchzugehen;
einen Bearbeitungskopf (3), der auf der Führungsstange (2) montiert ist, um die dünne Filmschicht zu mustern;
eine Walzenstation (4), die so angeordnet ist, dass sie dem Bearbeitungskopf (3) zugewandt ist und drehbar von dem Paar Trageteilen (1) getragen wird, wobei die Walzenstation (4) eine Außenumfangsfläche aufweist, auf der das Schichtsubstrat platziert wird; und
einen Transportmechanismus (5) zum Transportieren des Schichtsubstrats auf die Walzenstation (4) in einer Vorbereitungsphase, die dem Musterungsprozess vorangeht, und zum Transportieren des auf der Walzenstation (4) platzierten Schichtsubstrats nach dem Musterungsprozess,
**gekennzeichnet durch**
die Walzenstation (4), die zwischen dem Paar Trageteilen (1) angeordnet ist,
einen Walzen-Hebe-Senk-Mechanismus (12), wobei die Walzenstation (4) dazu imstande ist, **durch** die Walzen-Hebe-Senk-Mechanismen (12) von dem Paar Trageteilen (1) angehoben und in eine zurückgezogene Position abgesenkt zu werden, und in der zurückgezogenen Position unterhalb des Transportmechanismus (5) angeordnet ist.

2. Vorrichtung zur Musterung eines Schichtsubstrats nach Anspruch 1, wobei die Führungsstange (2) so getragen wird, dass sie dazu imstande ist, von dem Paar Trageteilen (1) angehoben und abgesenkt zu werden.

3. Vorrichtung zur Musterung eines Schichtsubstrats nach Anspruch 1 oder 2, wobei die Walzenstation (4) durch die Walzen-Hebe-Senk-Mechanismen (12) so getragen wird, dass zwei Enden von ihr unabhängig voneinander bezüglich des Paars Trageteile (1) angehoben und abgesenkt werden können.

4. Vorrichtung zur Musterung eines Schichtsubstrats nach einem der Ansprüche 1 bis 3, wobei der Bearbeitungskopf (3) bezüglich der Führungsstange (2) in einer Richtung (B) beweglich ist, die senkrecht zu einer Richtung (A) ist, in der das Schichtsubstrat transportiert wird.

5. Vorrichtung zur Musterung eines Schichtsubstrats nach einem der Ansprüche 1 bis 4, wobei der Transportmechanismus (5) eine Gruppe Spannfuttermechanismen (16) hat, um die Enden des Schichtsubstrats in einer Transportrichtung (A) zu klemmen, in der das Schichtsubstrat transportiert wird, wobei die Spannfuttermechanismen (16) in der Transportrichtung (A) stromaufwärts und stromabwärts auf beiden Seiten der Walzenstation (4) angeordnet sind.

6. Vorrichtung zur Musterung eines Schichtsubstrats nach Anspruch 5, wobei die Gruppe Spannfuttermechanismen (16) das Schichtsubstrat so klemmt, dass der auf der Walzenstation (4) platzierte Abschnitt des Schichtsubstrats höher als die Enden des Schichtsubstrats in der Transportrichtung (A) ist.

7. Vorrichtung zur Musterung eines Schichtsubstrats nach einem der Ansprüche 1 bis 6, mit außerdem einem Sensor (6) zum Messen des Abstands vom Sensor (6) zum auf der Walzenstation (4) platzierten Substrat, wobei der Sensor (6) an der Führungsstange (2) vorgesehen ist.

## Revendications

1. Dispositif de structuration pour former une rainure dans une couche de film mince d'un substrat laminé, le dispositif de structuration comprenant :
une paire de pièces de support (1) disposée à un intervalle prédéterminé ;
une barre de guidage (2) disposée entre la paire de pièces de support (1) et supportée à chaque extrémité par la paire de pièces de support (1), la barre de guidage (2) permettant au substrat laminé de passer sous celle-ci ;
une tête de traitement (3) montée sur la barre de guidage (2) pour structurer la couche de film mince ;
un train de roulement (4) disposé pour faire face à la tête de traitement (3) et est supporté rotativement par la paire de pièces de support (1), le train de roulement (4) inclut une surface périphérique externe sur laquelle le substrat laminé est placé ; et
un mécanisme de transport (5) pour transporter, dans une phase préparatoire précédant le processus de structuration, le substrat laminé sur le train de roulement (4) et transporter, après le processus de structuration, le substrat laminé placé sur le train de roulement (4),
**caractérisé par**
le train de roulement (4) disposé entre la paire de pièces de support (1)
un mécanisme de levage/d'abaissement de roulement (12),
dans lequel le train de roulement (4) est capable d'être levé et abaissé dans une position rétractée par la paire de pièces de support (1), par les mécanismes de levage/d'abaissement (12), et est disposé dans la position rétractée sous le mécanisme de transport (5).

2. Dispositif pour structurer un substrat laminé selon la revendication 1, dans lequel la barre de guidage (2) est supportée de façon à être capable d'être levée et abaissée par la paire de pièces de support (1).

3. Dispositif pour structurer un substrat laminé selon la revendication 1 ou 2, dans lequel le train de roulement (4) est supporté par les mécanismes de levage/d'abaissement de sorte que deux extrémités de celui-ci peuvent être levées et abaissées indépendamment l'une de l'autre par rapport à la paire de pièces de support (1).

4. Dispositif pour structurer un substrat laminé selon l'une quelconque des revendications 1 à 3, dans lequel la tête de traitement (3) est mobile par rapport à la barre de guidage (2) dans une direction (B) perpendiculaire à une direction (A) dans laquelle le substrat laminé est transporté.

5. Dispositif pour structurer un substrat laminé selon l'une quelconque des revendications 1 à 4, dans lequel le mécanisme de transport (5) a un groupe de mécanismes de mandrin (16) pour serrer les extrémités du substrat laminé dans une direction (A) de transport dans laquelle le substrat laminé est transporté, les mécanismes de mandrin (16) étant disposés en amont et en aval dans la direction (A) de transport de chaque côté du train de roulement (4).

6. Dispositif pour structurer un substrat laminé selon la revendication 5, dans lequel le groupe de mécanismes de mandrin (16) serre le substrat laminé de sorte que la partie du substrat laminé placée sur le train de roulement (4) est plus haute que les extrémités du substrat laminé dans la direction (A) de transport.

7. Dispositif pour structurer un substrat laminé selon l'une quelconque des revendications 1 à 6, comprenant en outre un capteur (6) pour mesurer la distance du capteur (6) au substrat laminé placé sur le train de roulement (4), le capteur (6) étant prévu sur la barre de guidage (2).
